# EUROPÄISCHE PATENTSCHRIFT

(11) **EP 2 545 598 B1**
(45) Veröffentlichungstag und Bekanntmachung des Hinweises auf die Patenterteilung: **26.02.2014**
(21) Anmeldenummer: 11713177.1
(22) Anmeldetag: 10.03.2011
(51) Int. Cl.: H01L 41/047, H01L 41/053, H01L 41/113, H01L 41/09

(54) **BIEGEWANDLER**
BENDING TRANSDUCER
TRANSDUCTEUR DE FLEXION

(30) Priorität: 11.03.2010 DE 102010011047
(43) Veröffentlichungstag der Anmeldung: 16.01.2013
(73) Patentinhaber: Johnson Matthey Catalysts (Germany) GmbH, 96257 Redwitz (DE)
(72) Erfinder: VAN DER LINDEN, Klaus, 96257 Redwitz (DE)
(74) Vertreter: FDST Patentanwälte
(86) Internationale Anmeldenummer: PCT/EP2011/001191
(87) Internationale Veröffentlichungsnummer: WO 2011/110353

(56) Entgegenhaltungen:
- EP-A1- 1 168 463
- EP-A2- 1 724 849
- WO-A1-2010/008381
- US-A1- 2002 140 321
- US-A1- 2007 188 053

## Beschreibung

Die Erfindung betrifft einen Biegewandler mit einem Schichtaufbau, umfassend ein piezoelektrisch aktives Element, bestehend aus einem piezoaktiven Material und darauf angebrachten Elektrodenschichten.

Piezoelektrische Biegewandler nutzen allgemein den piezoelektrischen Effekt aus, um eine mechanische Deformation des piezoaktiven Materials in ein elektrisches Signal umzuwandeln und umgekehrt. Biegewandler werden daher sowohl im Bereich der Sensorik, beispielsweise als Drucksensoren als auch der Aktorik, beispielsweise als Stellelemente, eingesetzt. Daneben ist der Einsatz von Biegewandlern als Generator zum Erzeugen von elektrischer Energie bekannt, beispielsweise aus der DE 10 2008 007 774 A1. Ein Einsatzgebiet dieser Energieerzeugung mittels Piezokeramik, auch als Energy Harvesting bezeichnet, ist beispielsweise die Stromversorgung eines Senders zur drahtlosen Übertragung eines Messsignals, beispielsweise eines Drucksignals aus einem in einem Reifen angeordneten Reifendrucksensor zu einem außerhalb des Reifens angeordneten Empfänger.

Zur Ausnutzung des piezoelektrischen Effekts ist eine elektrische Kontaktierung des piezoaktiven Materials erforderlich. Dies erfolgt über so genannte Elektrodenschichten, die beidseitig auf dem piezoaktiven Material aufgebracht sind. Die Elektrodenschichten sind in der Regel durchgängige Schichten, können aber auch eine Strukturierung aufweisen.

Ein aus einem derartigen Schichtaufbau gebildetes piezoelektrisch aktives Element ist oftmals auf einem mechanischen Träger aufgebracht. Ist lediglich ein piezoelektrisch aktives Element, also ein piezoaktives Material mit darauf angebrachten Elektrodenschichten, einseitig auf einem derartigen mechanischen Träger aufgebracht, so spricht man von einem Monomorph-Biegewandler. Ist ein derartig piezoelektrisch aktives Element beidseitig auf dem mechanischen Träger aufgebracht, so spricht man von einem trimorphen Biegewandler. Unter Bimorph-Biegewandler wird der Verbund zweier piezoelektrisch aktiver Elemente ohne mechanischen Träger verstanden. Die beiden miteinander verbundenen piezoelektrisch aktiven Elemente teilen sich dabei eine gemeinsame Elektrodenschicht. Bei einem Multimorph-Aufbau sind allgemein mehr als zwei piezoelektrisch aktive Elemente miteinander schichtweise verbunden.

Als piezoaktives Material wird üblicherweise eine Piezokeramik, insbesondere eine so genannte PZT-Keramik (Blei-Zirkonat-Titan) eingesetzt.

Grundsätzlich wird eine möglichst hohe mechanische Biegung oder Deformation des Biegewandlers angestrebt, um ein möglichst großes elektrisches Signal zu erzeugen, insbesondere bei der Anwendung zur Energieerzeugung. Dem steht die sehr spröde Materialcharakteristik des piezoaktiven Materials gegenüber. Allgemein gilt zur Vermeidung eines Schadens, wie beispielsweise eines Bruchs des piezoaktiven Materials die Vorgabe, dass eine Piezokeramik maximal etwa 1%o auf Dehnung und etwa maximal 1 % auf Druck belastet werden darf. Dies bedeutet, dass eine relative Längenänderung ΔL/L bei einer Dehnung (Streckung) maximal 0,001 und bei einer Druckbelastung (Stauchung) maximal bei 0,01 liegen darf. Darüber hinausgehende Belastungen können zu einer Zerstörung der Piezokeramik führen. Dabei ist zu berücksichtigen, dass die Schichten aus dem piezoaktiven Material (Piezokeramik) extrem dünn sind und beispielsweise eine Schichtdicke lediglich im Bereich von 50 bis 400µm aufweisen. Bei der Piezokeramik-Schicht handelt es sich daher um eine extrem dünne und spröde Folie. Aus der DE 33 10 589 A1 ist für eine einfachere Handhabung bei der Herstellung vorgesehen, dass die Piezokeramik mit einem Kunstharz imprägniert wird, bevor die Elektrodenschichten aufgebracht werden, und dass anschließend eine Aushärtung des Kunstharzes zu einem Duroplasten erfolgt.

Aus dem Stand der Technik sind unterschiedlichste Aufbauvarianten von piezoelektrischen Elementen zu entnehmen. So ist aus der EP 1 168 463 A1 ein Laminatwerkstoff zu entnehmen, in dem ein mehrlagiger piezoelektrischer Aktuator eingebettet ist. Der piezoelektrische Aktuator ist dabei über Anschlussleitungen durch die einzelnen Laminatschichten hindurch mit einem Anschlusselement verbunden.

In der WO 2010/008381 A1 ist ebenfalls die Einbettung eines piezoelektrischen Elements in einer Isolationsstruktur beschrieben.

Aus der EP 1 724 849 A2 ist mehrlagiger Biegewandler zu entnehmen, der zum Schutz der Piezoelemente vor äußeren Einflüssen mit einer Schutzoberfläche wie beispielsweise ein Schutzlack überzogen ist.

Aus der US 2002/0140321 A1 ist eine Ausführungsvariante eines Biegewandlers zu entnehmen, welcher von einer isolierenden Schutzbeschichtung umgeben ist.

Der Erfindung liegt die Aufgabe zugrunde, einen Biegewandler mit einer verbesserten Belastbarkeit anzugeben.

Die Aufgabe wird gemäß der Erfindung gelöst durch einen Biegewandler mit einem Schichtaufbau, umfassend ein piezoelektrisch aktives Element, bestehend aus einem piezoaktiven Material und darauf angebrachten Elektrodenschichten, wobei der Schichtaufbau außenseitig eine Schutzschicht aufweist. Die Schutzschicht ist hierbei in geeigneter Weise auf den Schichtaufbau bzw. gegebenenfalls auf das piezoaktive Material, insbesondere mit Hilfe einer Kleberschicht nach Art eines Laminats aufgebracht. Die Schutzschicht bildet eine Trägerschicht für Leiterbahnen oder Leiterschichten. Unter außenseitig wird hierbei die oberste bzw. unterste Schicht (äußere Flachseite) des Schichtaufbaus verstanden, die üblicherweise durch eine Elektrodenschicht gebildet ist. Der Schichtaufbau ist sandwichartig zwischen zwei die Schutzschichten bildende Folie mit integrierten Leiterbahnen bzw. mit aufgebrachter leitfähigen Schicht angeordnet. Weiterhin ist vorgesehen, dass die Leiterbahnen in Anschluss- oder Kontaktflächen münden, an denen im angeschlossenen Zustand Anschlussdrähte bevorzugt durch Löten kontaktiert sind. Gemäß einer zweckdienlichen Weiterbildung stehen die Schutzschichten dabei wechselseitig über den Schichtaufbau über und im überstehenden Teilbereich sind die Kontaktflächen ausgebildet, wodurch eine einfach Kontaktierung ermöglicht ist.

Untersuchungen haben gezeigt, dass mit einer derartigen elastischen Schutzschicht versehene Biegewandler eine - im Vergleich zu einer Ausführungsvariante ohne elastische Schutzschicht - um mehr als den Faktor 10 höhere Belastbarkeit sowohl für die Dehnungsbelastung als auch für die Druckbelastung zeigt.

Insgesamt ist daher der Biegewandler nach Art eines Laminats, bestehend aus dem Schichtaufbau und der auf der Außenseite des Schichtaufbaus angebrachten elastischen Schutzschicht ausgebildet.

Gemäß einer bevorzugten Ausgestaltung ist die Schutzschicht unter einer Vorspannung auf den Schichtaufbau, also auf die äußerste Schicht des Schichtaufbaus, aufgebracht. Die Verbindung zwischen der Schutzschicht und dem Schichtaufbau ist daher nicht spannungsfrei. Vielmehr übt die Schutzschicht in der Verbindungsebene zum Schichtaufbau eine Vorspannung aus, vorzugsweise eine Druckbelastung. Durch diese quasi von extern ausgeübte Vorspannung wird einem frühzeitigen Versagen oder Bruch des Schichtaufbaus bei einer (Biege-) Belastung effektiv entgegengewirkt.

Die Vorspannung weist hierbei insbesondere keine Vorzugsrichtung auf. Sie kann jedoch gezielt in eine Richtung orientiert sein, bevorzugt in Längsrichtung des Biegewandlers, so dass die Vorspannung in die gleiche Richtung orientiert ist wie die beim Biegen auftretenden Druckspannungen.

Die Vorspannung wird beim Aufbringen der Schutzschicht auf den Schichtaufbau erzeugt. Hierzu stehen - je nach Art der Schutzschicht - unterschiedliche Möglichkeiten offen. Bei einer elastischen Schutzschicht wird diese beispielsweise durch Vordehnung der Schutzschicht erreicht, die im vorgedehnten Zustand aufgebracht wird, so dass die elastische Rückstellkraft die Vorspannung ausübt. Alternativ wird die Schutzschicht durch eine aushärtbare Masse, beispielsweise in Form eines sogenannten Prepregs oder auch als Lack, aufgebracht. Vorzugsweise werden hierbei die Masse und / oder die Prozessparameter beim Aufbringen der Masse derart gewählt, dass beim Aushärten die Vorspannung erzeugt wird, insbesondere durch einen Schrumpfungsprozess. Falls auch der Schichtaufbau durch den gewählten Herstellungsprozess eine Längenänderung erfährt, ist die Schrumpfung der aufgebrachten Schutzschicht größer als die des Schichtaufbaus. Die Vorspannung wird hierbei insbesondere durch einen thermischen Prozess, also durch eine Wärmebehandlung mit anschließendem Abkühlen erzeugt. Beispielsweise wird die Schutzschicht vor dem Verbinden mit dem Schichtaufbau erwärmt, anschließend beispielsweise durch Kleben mit diesem verbunden, um dann im verbundenen Zustand abzukühlen.

Gemäß einer bevorzugten Ausgestaltung ist vorgesehen, dass die Schutzschicht einen anderen, vorzugsweise größeren thermischen Ausdehnungskoeffizienten als der Schichtaufbau aufweist, insbesondere als dessen äußerste Schicht, um zuverlässig eine thermische Vorspannung zu erzeugen.

Ergänzend oder Alternativ zur Vorspannung weist gemäß einer bevorzugten Weiterbildung die Schutzschicht eine höhere Elastizität und / oder ein höheres E-Modul als der Schichtaufbau, insbesondere als das piezoaktiven Materials auf. Hierdurch wird die Bruchgefahr weiter reduziert. Unter höherer Elastizität wird hierbei verstanden, dass das Material der elastischen Schutzschicht eine insbesondere deutlich höhere Dehn- oder Streckgrenze aufweist. Als Streckgrenze wird allgemein im Spannungs-Dehnungs-Diagramm die Spannung verstanden, bis zu der das Material nur eine elastische, jedoch keine plastische Verformung zeigt. Unter Elastizitätsmodul E wird allgemein der Quotient zwischen der Spannung und der Dehnung im linearen elastischen Bereich im Spannungs-Dehnungs-Diagramm verstanden. Das Elastizitätsmodul gibt also die (konstante) Steigung im linear elastischen Bereich im Diagramm an.

Vorzugsweise ist die Dicke der Schutzschicht größer als 50µm, vorzugsweise größer 100µm und liegt insbesondere im Bereich bis etwa 1.000µm. Die Dicke der Schutzschicht ist insbesondere größer als die Dicke der jeweiligen Elektrodenschicht. Die Dicke der Elektrodenschichten liegt beispielsweise bei der Verwendung von Gold-Elektroden im Bereich von einigen 100nm und bei der Verwendung von so genannten Karbon-Elektroden, beispielsweise im Bereich von 5 bis 50µm. Die Dicke des piezoaktiven Materials selbst liegt beispielsweise im Bereich zwischen 50 bis 400µm.

Der Biegewandler kann hierbei durch unterschiedliche Schichtaufbauten charakterisiert sein. So kann der Biegewandler beispielsweise lediglich ein piezoelektrisch aktives Element aufweisen, also ein piezoaktives Material mit beidseitig darauf angebrachten Elektrodenschichten, ohne weitere mechanischen Tragschichten und ohne weitere ergänzende piezoelektrisch aktive Elemente. Auf dieses einzige piezoelektrisch aktive Element ist beidseitig die Schutzschicht aufgebracht. Bei einem Aufbau mit einer mechanischen Tragschicht, wie beispielsweise bei einem monomorphen oder auch trimorphen Aufbau wird der mechanische Träger vorliegend zum Schichtaufbau gezählt. Bei einer monomorphen Ausgestaltung schließt der mechanisch Träger den Schichtaufbau zu einer Seite ab. Bei dieser Ausführungsvariante kann lediglich auf einer Seite des Schichtaufbaus die Schutzschicht aufgebracht sein, nämlich auf der dem mechanischen Träger abgewandten Seite, da der mechanische Träger üblicherweise einen ausreichend großen stabilisierenden Effekt ausübt.

Bei einer trimorphen Ausgestaltung, bei der also beidseitig eines mechanischen Trägers jeweils ein piezoelektrisch aktives Element aufgebracht ist und der Schichtaufbau daher aus dem mechanischen Träger und zwei auf dessen gegenüberliegenden Seiten angebrachten piezoelektrisch aktiven Elementen besteht, ist die Schutzschicht außenseitig auf beiden Außenseiten des Schichtaufbaus, also auf den äußeren Seiten des piezoelektrisch aktiven Elements aufgebracht. Prinzipiell das Gleiche gilt auch, wenn auf dem mechanischen Träger entweder beidseitig oder an einer Seite eine Mehrzahl von piezoelektrisch aktiven Elementen nach Art von Stapeln (Stacks) aufgebracht sind.

Bei einer bimorphen oder multimorphen Ausgestaltung, bei der der Schichtaufbau gebildet ist durch mehrere miteinander verbundene piezoelektrisch aktive Elemente ohne einen mechanischen Träger, sind wiederum vorzugsweise an den gegenüberliegenden Außenseiten des Schichtaufbaus jeweils eine elektrische Schutzschicht aufgebracht.

Der Biegewandler weist allgemein eine so genannte neutrale Zone auf, die gebildet ist durch eine Mittenebene des Schichtaufbaus, die üblicherweise parallel zu den Schichten des Schichtaufbaus verläuft. Gemäß einer bevorzugten Ausgestaltung ist vorgesehen, dass der Schichtaufbau bezüglich der neutralen Zone des Biegewandlers asymmetrisch angeordnet ist, dass also die Mittenebene des Schichtaufbaus nicht mit der Mittenebene des Biegewandlers zusammenfällt. Vorzugsweise ist weiterhin vorgesehen, dass der Schichtaufbau vollständig aus der neutralen Zone herausgeführt ist derart, dass die neutrale Zone außenseitig am Schichtaufbau angrenzt bzw. sogar außerhalb des Schichtaufbaus angeordnet ist. Diese Ausgestaltung ist insbesondere bei einer Anwendung des Biegewandlers als Generator zur Energieerzeugung von besonderem Vorteil, um eine sinnvolle Energiemenge generieren zu können. Gemäß einer bevorzugten Ausgestaltung ist dabei vorgesehen, dass der Biegewandler derart eingesetzt und montiert ist, dass der Biegewandler lediglich in eine Richtung belastet (gebogen) wird und zwar derart, dass der Schichtaufbau - aufgrund der Anordnung außerhalb der neutralen Zone des Biegewandlers - ausschließlich auf Druck belastet wird, da die Piezokeramik gegenüber Druckbelastungen widerstandsfähiger ist.

Gemäß einer zweckdienlichen Ausgestaltung wird dies durch eine asymmetrische Ausgestaltung der beiden außenseitig aufgebrachten Schutzschichten erreicht. Die beiden Schutzschichten unterscheiden sich also in ihren Dicken derart, dass der Schichtaufbau bezüglich der neutralen Zone - im Vergleich zu einem symmetrischen Aufbau - verschoben wird. Vorzugsweise ist dabei die Dicke der dickeren Schutzschicht größer gleich der Gesamtdicke des Schichtaufbaus und der dünneren Schutzschicht.

Als insbesondere elastische Schutzschicht wird gemäß einer bevorzugten Ausgestaltung eine auflaminierte Kunststofffolie eingesetzt. Hierunter wird insbesondere das Aufkleben einer handelsüblichen Laminierfolie verstanden, die beispielsweise aus PVC oder einem anderen thermoplastischen Kunststoffmaterial ausgebildet ist. Eine derartige Kunststofffolie wird auf den Schichtaufbau auflaminiert, also aufgeklebt. Handelsübliche Laminierfolien weisen hierzu eine spezielle Beschichtung auf, die bei Wärmeeinwirkung klebrig wird und somit eine Klebschicht ausbildet.

Gemäß einer bevorzugten Alternative besteht die Schutzschicht aus einem flexiblen Leiterplattenmaterial, beispielsweise das so genannte FR3 oder insbesondere das FR4-Material. Derartiges Leiterplattenmaterial besteht üblicherweise aus einem ausgehärteten Epoxidharz. Das FR4-Material ist hierbei ein glasfaserverstärktes Epoxidharz. Derartige Folien aus Leiterplattenmaterial sind auf dem Markt in einfacher Weise und in vielfältigen Ausführungsvarianten erhältlich. Auch die Schutzschicht aus diesem Leiterplattenmaterial ist vorzugsweise auf den Schichtaufbau aufgeklebt.

Unmittelbar auf die Schutzschicht ist eine Anzahl von Leiterbahnen oder auch eine leitfähige Schicht aufgebracht. Insbesondere ist die Schutzschicht dabei eine Tragschicht einer flexiblen Leiterplatte. Hierdurch ist eine besonders einfache und dauerhaft zuverlässige elektrische Kontaktierung der Piezokeramik bzw. der jeweiligen auf der Piezokeramik aufgebrachten Elektrodenschicht ermöglicht. Die Kontaktierung erfolgt daher mit Hilfe dieser zusätzlich außenseitig angebrachten Schutzschicht. Bei dieser Ausführungsvariante ist zur Verbindung mit dem Schichtaufbau die Verwendung insbesondere eines Leitklebers möglich, so dass eine leitfähige Verbindung zwischen den Leiterbahnen bzw. der Tragschicht und der Elektrodenschicht des Schichtaufbaus ausgebildet ist. Die leitfähige Verbindung kann auf jeden Fall aber auch durch die Verwendung einer extrem dünnen Klebeschicht geschehen.

Insbesondere bei der Ausgestaltung als Tragschicht einer flexiblen Leiterplatte mit darauf angebrachten Leiterbahnen ist der gesamte Biegewandler als ein vorgefertigtes elektromechanisches Bauteil ausgebildet, welches lediglich noch an dafür vorgesehenen Kontaktpunkten, die insbesondere an der Leiterplatte ausgebildet sind, kontaktiert und angeschlossen zu werden braucht. Prinzipiell besteht auch die Möglichkeit, unmittelbar auf die flexible Leiterplatte weitere elektronische Bauelemente oder Schaltkreise anzuordnen. Die die Schutzschicht bildende flexible, insbesondere folienartige Leiterplatte steht über den Schichtaufbau randseitig über und weist im überstehenden Teilbereich eine Kontaktfläche zur Kontaktierung des Biegewandlers mit einer Anschlussleitung auf.

Die Ausbildung der Leiterbahnen oder auch der leitfähigen Schicht auf der Schutzschicht erfolgt hier beispielsweise durch an sich bekannte Verfahren insbesondere aus der Leiterplattentechnologie, wie beispielsweise Aufsputtern, Aufgalvanisieren, Aufkleben oder Aufwalzen.

Gemäß einer bevorzugten Weiterbildung bildet die leitfähige, unmittelbar auf der Schutzschicht angebrachte Schicht zugleich eine Elektrode für das piezoelektrische Element, d.h. die leitfähige Schicht kommt unmittelbar mit der Piezokeramik gegebenenfalls unter Vermittlung eines Leitklebers in Kontakt.

Gemäß einer dritten alternativen Ausgestaltung ist die Schutzschicht durch eine Lackschicht gebildet. Unter Lackschicht wird hierbei eine Schicht verstanden, die durch Auftragen wie beispielsweise durch Sprühen, Streichen, Walzen, eines geeigneten Lackes, beispielsweise ein Kunstharzlack, in zähflüssigem Zustand auf den Schichtaufbau ausgebildet wird und die nach dem Auftragen beispielsweise durch Verdampfen eines Lösungsmittels aushärtet. Grundsätzlich besteht allgemein die Möglichkeit, ergänzend zur Schutzschicht die Piezokeramik zusätzlich mit einem geeigneten Lack zur Verbesserung der mechanischen Eigenschaften zu imprägnieren.

In bevorzugter Ausgestaltung ist der Biegewandler insgesamt durch die Anordnung der Schutzschicht derart ausgebildet, dass er zumindest bis etwa 10% bei einer Druckbelastung gestaucht und/oder zumindest bis etwa 1% bei einer Dehnungsbelastung gedehnt werden kann, ohne dass er beschädigt wird. Der Biegewandler mit der Schutzschicht ist daher deutlich stärker reversibel belastbar als ein Biegewandler ohne die Verwendung einer derartigen Schutzschicht. Zweckdienlicherweise wird der Biegewandler als Aktor, als Sensor und insbesondere zur Energieerzeugung als Generator eingesetzt. Bevorzugt wird er als Generator bei einem Reifendrucksensor für die Bereitstellung von Energie für eine drahtlose Signalübertragung eingesetzt.

Ausführungsvarianten der Erfindung werden nachfolgend anhand der Figuren näher erläutert. Diese zeigen jeweils in schematischen und stark vereinfachten, teilweise ausschnittsweisen Darstellungen:
- Fig. 1A: einen Biegewandler in einer Seitenansicht,
- Fig. 1B: eine Aufsicht auf den Biegewandlers gemäß Fig. 1A unter Weglassung der oberen Schutzschicht,
- Fig. 2A: einen Biegewandler einer weiteren Ausführungsvariante in einer Seitenansicht,
- Fig. 2B: eine Aufsicht auf den Biegewandler gemäß Fig. 2A,
- Fig. 3: eine Seitenansicht eines Biegewandler in Monomorph-Ausgestaltung und
- Fig. 4: eine Seitenansicht eines Biegewandlers in Trimorph-Ausgestaltung.

In den Figuren sind gleich wirkende Teile mit den gleichen Bezugszeichen versehen.

Die in den Figuren dargestellten unterschiedlichen Ausführungsvarianten an Biegewandlern 2 erstrecken sich in Längsrichtung 3 und weisen jeweils zumindest ein piezoelektrisch aktives Element 4 auf. Dieses besteht allgemein aus einer Schicht aus einem piezoaktiven Material, insbesondere einer Piezokeramik 6 (vorzugsweise PZT-Keramik). Beidseitig auf der Piezokeramik 6 sind Elektrodenschichten 8 angebracht. Die Piezokeramik 6 mit den Elektrodenschichten 8 bilden jeweils das piezoelektrisch aktive Element 4.

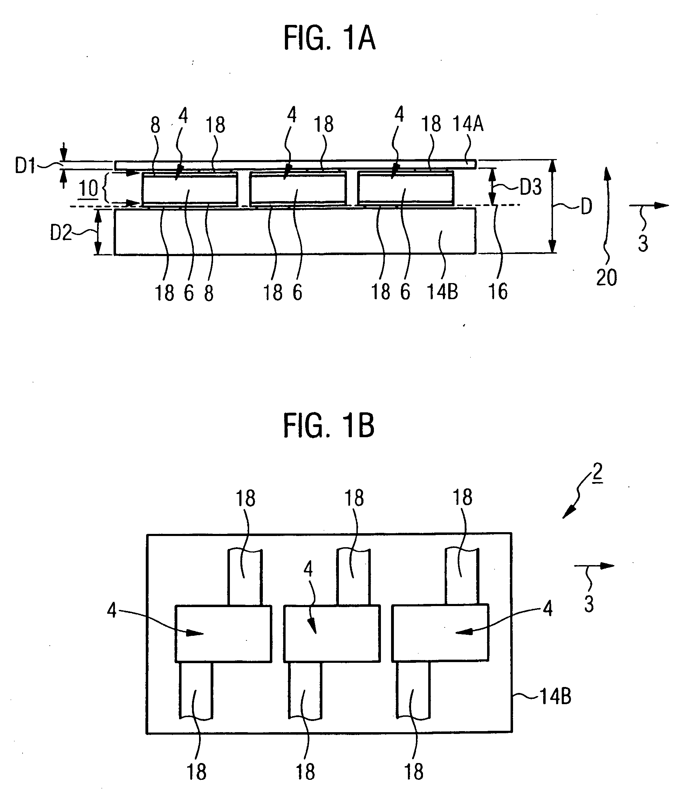

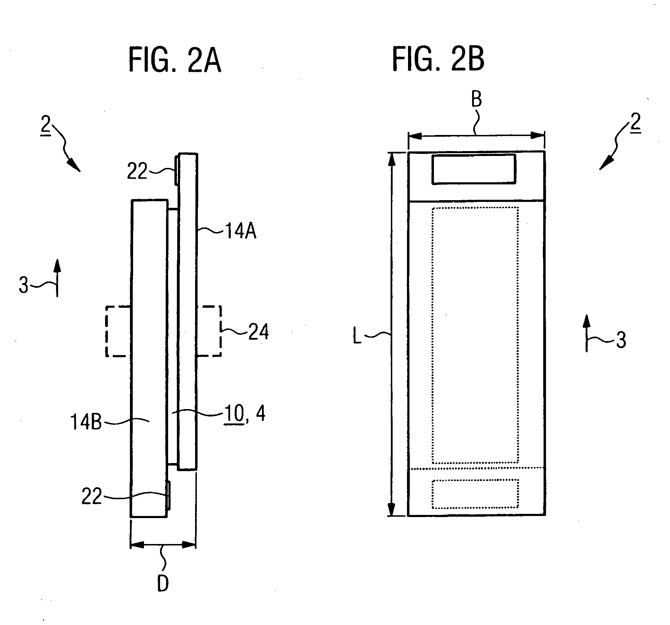

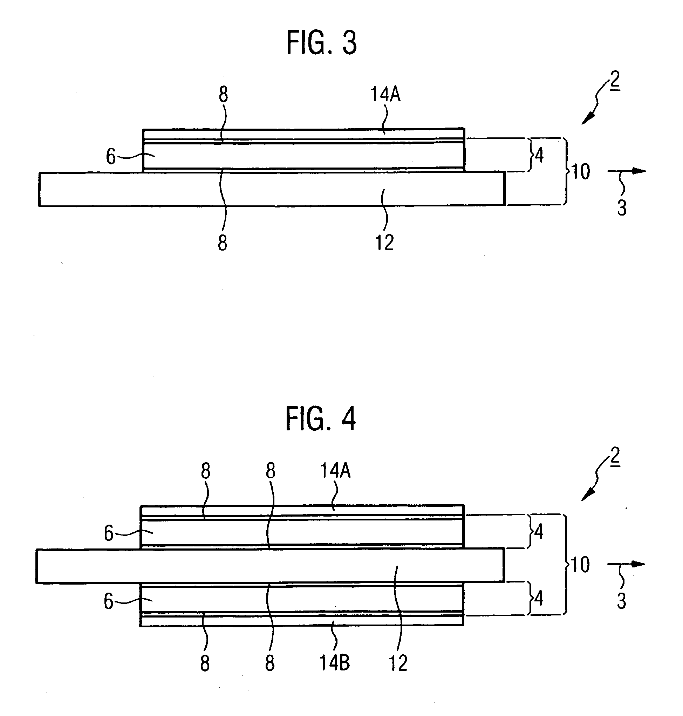

Das piezoelektrisch aktive Element 4 bildet in den Ausführungsvarianten nach Fig. 1A,1B sowie 2A,2B zugleich einen Schichtaufbau 10. Bei der in Fig. 3 dargestellten Monomorph-Ausgestaltung ist der Schichtaufbau 10 gebildet durch einen mechanischen Träger 12, auf dessen einer Seite das piezoelektrisch aktive Element 4 angebracht ist. Bei der Trimorph-Ausführungsvariante gemäß Fig. 4 ist der Schichtaufbau 10 gebildet durch den mechanischen Träger 12 sowie die beidseitig darauf angebrachten piezoelektrisch aktiven Elemente 4. Der mechanische Träger selbst ist an sich in unterschiedlichen Ausführungsvarianten bekannt und ist beispielsweise aus einem Isoliermaterial oder auch aus einem leitfähigen Material, wie beispielsweise einem Metall, ausgebildet. Bei der Ausgestaltung als leitfähiges Element kann hierbei auf die angrenzende Elektrodenschicht 8 verzichtet werden. Die Dicke des Trägers 12 ist üblicherweise größer als die des piezoaktiven Elements 4 und liegt typischerweise im Bereich von 0,2 bis 3 mm. Die Herstellung dieser unterschiedlichen Schichtaufbauten 10 ist an sich bekannt.

Alle in den Figuren dargestellten Biegewandler 2 zeichnen sich durch die zusätzliche Anordnung zumindest einer beispielsweise elastischen Schutzschicht 14A,B aus, die insbesondere unter Vorspannung auf den Schichtaufbau 10 aufgebracht ist. Sie übt also innerhalb der Verbindungsebene, zumindest in Orientierung der Längsrichtung 3 eine Druck- oder Schubbelastung aus. Die durch die Vorspannung ausgeübte Kraft ist daher von einem äußeren Bereich zu einem mittleren Bereich gerichtet.

Während bei der Monomorph-Ausgestaltung gemäß Fig. 3 lediglich eine Schutzschicht 14A außenseitig auf den Schichtaufbau 10 aufgebracht ist, sind bei den anderen Ausführungsvarianten jeweils an beiden gegenüberliegenden Außenseiten des Schichtaufbaus 10 jeweils eine Schutzschicht 14A,14B angebracht. Die Schutzschichten 14A,14B sind hierbei vorzugsweise jeweils mit Hilfe eines geeigneten Klebers, basierend zum Beispiel auf Acrylaten oder Epoxidharzen aufgebracht. Gegebenenfalls kann auch ein leitfähiger Kleber verwendet werden. Die Schutzschichten 14A,14B weisen vorzugsweise eine größere Fläche als der Schichtaufbau 10 auf, so dass sie den Schichtaufbau zumindest in einer Richtung randseitig überlappen.

Generell zeichnen sich die Ausführungsvarianten gemäß den Fig. 1A, 1B, 2A,2B sowie Fig. 4 dadurch aus, dass der Schichtaufbau sandwichartig zwischen zwei folienartigen Schutzschichten eingeklebt ist.

Bei der Ausführungsvariante gemäß den Fig. 1A, 1B ist kein durchgehendes piezoelektrisch aktives Element vorgesehen, sondern vielmehr sind einzelne Segmente an piezoelektrisch aktiven Elementen 4 zwischen den beiden Schutzschichten 13A,13B angeordnet.

In Fig. 1A ist als gestrichelte Linie ergänzend noch eine neutrale Zone 16 des Biegewandlers 2 angedeutet. Die neutrale Zone 16 ist hierbei gebildet durch eine parallel zu den einzelnen Schichten verlaufende Mittenebene, die also zu den äußeren Flachseiten des Biegewandlers 2, die durch die äußeren Flachseiten der beiden Schutzschichten 14A,14B gebildet sind, den gleichen Abstand aufweist. Wie aus Fig. 1A zu erkennen ist, ist der Schichtaufbau 10 bezüglich dieser neutralen Zone 16 asymmetrisch angeordnet und insbesondere vollständig aus der neutralen Zone 16 herausgeführt. Im Ausführungsbeispiel grenzt der Schichtaufbau 10 unmittelbar an die neutrale Zone 16 an.

Im Ausführungsbeispiel wird dies durch eine unterschiedliche Dicke der beiden Schutzschichten 14A,14B erreicht. Die obere Schutzschicht 14A weist hierbei eine deutlich geringere Dicke D1 auf im Vergleich zu der Dicke D2 der unteren Schutzschicht 14B. Im Ausführungsbeispiel entspricht die Dicke D2 der Summe der Dicke D1 und der Dicke D3 des Schichtaufbaus 10. Typischerweise liegt die Dicke D3 für den Schichtaufbau 10 bei Verwendung nur einer Piezokeramik 6 Schicht im Bereich beispielsweise von 50 bis etwa 500µm. Die beidseitig auf die Piezokeramik 6 angebrachten Elektrodenschichten 8 weisen jeweils eine Dicke auf, die je nach Ausgestaltung der Elektrodenschicht variieren kann und beispielsweise bei der Verwendung von Gold-Elektroden bei einigen 100nm liegt. Bei der Verwendung von Karbon-Elektroden beträgt die Dicke der Elektrodenschicht beispielsweise 5 bis 50µm. Unter Karbon-Elektroden werden allgemein Elektroden aus einem Karbonpolymer verstanden, bei dem ein hitzehärtendes Harz (z. B. Epoxidharz) mit Graphit als zusätzliche eingelagerte Pigmentteile aufgebracht ist.

Die Schutzschichten 14A, 14B sind vorzugsweise aus einem Leiterplattenmaterial, beispielsweise dem so genannten FR4-Material ausgebildet. Dieses ist ein glasfaserverstärktes ausgehärtetes Epoxidharz. Die Dicke der Schutzschichten 14A,14B ist vorzugsweise größer als 100µm. Im Ausführungsbeispiel wird beispielsweise ein Schichtaufbau 10 mit einer Dicke D3 von 200 bis 500 µm und eine obere Schutzschicht 14A mit einer Dicke D1 im Bereich von 100 bis 200µm verwendet. Die Dicke D2 der unteren Schutzschicht 14B liegt dann im Bereich von 400 bis 700µm.

Auf die Schutzschichten 14A,14B sind im Ausführungsbeispiel der Fig. 1A,1B leitfähige Bereiche nach Art von Leiterbahnen 18 aufgebracht. Die Schutzschicht 14A,14B bildet zusammen mit den Leiterbahnen 18 eine folienartige flexible Leiterplatte aus. Die Schutzschichten 14A,14B sind in diesem Fall die Tragschichten von diesen flexiblen Leiterplatten, auf denen die Leiterbahnen18 aufgebracht sind. Über die Leiterbahnen 18 erfolgt jeweils eine Kontaktierung der einzelnen Elektrodenschichten 8 in besonders einfacher und effizienter Weise. Über die Leiterplatten und deren Leiterbahnen 18 kann daher in einfacher Weise die Ab- und Weiterleitung der bei einer mechanischen Verformung erzeugten elektrischen Signale (elektrische Ladungsträger) erfolgen. Die Kontaktierung der einzelnen Leiterbahnen 18 zur Weiterleitung an eine nachgeschaltete Steuereinheit oder einen Energiespeicher geschieht hierbei über nicht näher dargestellte Kontakte, die beispielsweise durch verbreiterte Kontaktflächen der Kontaktbahnen 18 gebildet sind, an denen beispielsweise Anschlussdrähte angelötet sind, etc. Bei der Aufsicht gemäß Fig. 1 B sind die Anschlussmöglichkeiten der Leiterbahnen 18 nicht dargestellt. Diese sind lediglich schematisch durch abgehende und nur teilweise dargestellte Leiterbahnen 18 illustriert.

Zur Ausbildung der unteren Schutzschicht 14B mit der großen Dicke D2 können auch mehrere Lagen von einzelnen Folien der Schutzschichten übereinander angeordnet werden. Ein derartiger Biegewandler, wie er in Fig. 1A dargestellt ist, wird beispielsweise an einer Endseite, beispielsweise an seinem linken Ende, in eine Halteeinrichtung eingespannt, wohingegen das gegenüberliegende, rechte Ende ein Freiende bildet. Dieses wird im eingebauten Zustand vorzugsweise lediglich in eine durch den Pfeil 20 angedeutete Biegerichtung ausgelenkt, so dass die einzelnen piezoelektrischen Elemente 4 ausschließlich auf Druck belastet werden.

Das Ausführungsbeispiel gemäß den Fig. 2A,2B entspricht weitgehend dem Ausführungsbeispiel gemäß den Fig. 1A, 1B. Auch hier ist der Biegewandler 2 gebildet durch zwei gegenüberliegende Schutzschichten 14A,14B unterschiedlicher Dicke mit einem dazwischen angeordneten (einzigen) piezoelektrischen Element 4. Die Schutzschichten 14A,14B überstehen - wie bereits auch im Ausführungsbeispiel der Fig. 1A und 1B - das piezoelektrische Element 4. Bei der Variante gemäß den Fig. 2A,2B überstehen die Schutzschichten 14A,14B in Längsrichtung des Biegewandlers 2 das piezoelektrische Element 4 unterschiedlich weit, so dass die beiden Schutzschichten 14A,14B in Längsrichtung versetzt zueinander angeordnet sind und zueinander einen überstehenden Bereich aufweisen. In diesen überstehenden Bereichen sind auf den Innenseiten der Schutzschichten 14A,14B Kontaktflächen 22 ausgebildet, an die beispielsweise ein Anschlussdraht angelötet wird. Auch hier ist vorzugsweise vorgesehen, dass die Schutzschichten 14A,14B mit hier nicht näher dargestellten Leiterbahnen 18 zur Kontaktierung der ebenfalls nicht näher dargestellten Elektrodenschichten 8 versehen sind.

In Fig. 2A ist etwa mittig im Bereich des Biegewandlers durch eine gestrichelte Linie noch eine mögliche Lagerungsstelle 24 angedeutet, in der der Biegewandler 2 in seiner montierten Endstellung beispielsweise eingespannt ist. Die Fig. 2B zeigt im Vergleich zu der Fig. 2A eine um 90° gedrehte Ansicht ohne die Lagerungsstelle 24. Die Breite B eines Biegewandiers 2 liegt allgemein typischerweise im Bereich zwischen 3 und 10mm und im Ausführungsbeispiel beispielsweise bei 5,5mm. Die Länge L eines typischen Biegewandlers 2 liegt beispielsweise im Bereich von 20 bis 50mm und im Ausführungsbeispiel beispielsweise bei etwa 30mm. Die Gesamtdicke D eines typischen Biegewandlers liegt beispielsweise im Bereich von 400 bis 1.500µm und in den Ausführungsbeispielen gemäß den Fig. 1A und 2A im Bereich von etwa 650µm.

Bei den in den Figuren gezeigten Ausführungsbeispielen ist jeweils die Schutzschicht 14A,14B als zusätzliche Schicht mit darauf angebrachten Leiterbahnen 18 auf den Schichtaufbau 10 mit den Elektrodenschichten 8 außenseitig angebracht. In einer alternativen Ausführungsvariante ist vorgesehen, dass auf den Schutzschichten 14A,14B eine leitfähige Schicht angebracht ist, die die Elektrodenschichten 8 ausbilden.

Sämtliche Ausführungsbeispiele zeichnen sich durch die Verwendung einer Schutzschicht 14A,14B aus, wobei vorzugsweise der Schichtaufbau 10 zwischen zwei Schutzschichten 14A,14B eingeklebt ist. Durch diese Maßnahme wird die Belastbarkeit des Schichtaufbaus deutlich erhöht und die Bruchgefahr wird reduziert. Es sind durch diese Maßnahme insgesamt deutlich höhere Biegebeanspruchungen des Biegewandlers 2 ermöglicht.

Ein weiteres besonderes Gestaltungsmerkmal ist darin zu sehen, dass der piezoelektrisch aktive Schichtaufbau 10 aus der neutralen Zone 16 des Biegewandlers 2 herausgebracht ist, um für einen Generatorbetrieb eine sinnvolle Energieerzeugung zu ermöglichen. Weiterhin ist die Anbringung der Leiterbahnen 18 oder einer leitfähigen Schicht unmittelbar auf der Schutzschicht 14A,14B insbesondere zur Ergänzung der auf der Piezokeramik 6 angebrachten Elektrodenschicht 8 hervorzuheben. Durch die Leiterbahnen 18 wird nämlich eine besonders einfache Kontaktierung der Elektrodenschichten 8 ermöglicht. Insgesamt ist dadurch ein hoch belastbarer Biegewandler 2 ausgebildet, der über eine einfach realisierbare und selbst bei hohen Biegebeanspruchungen zuverlässig funktionierende Kontaktierung verfügt. Insbesondere bei einer Ausgestaltung, bei der eine auf die Schutzschichten 14A und 14B aufgebrachte leitfähige Schicht selbst die Elektrodenschicht bildet (oder auch ergänzend zu den Elektroden 8 vorgesehen ist), ist eine besonders robuste Kontaktierung gegeben. Denn selbst bei einem eventuellen Riss der Piezokeramik 6 ist diese immer noch zuverlässig vollflächig kontaktiert, ohne dass Teile der Flächen der Piezokeramik 6 unkontaktiert bleiben. Die Leiterbahnen 18 bzw. leitfähigen Schichten sind beispielsweise durch Sputtern, Drucken oder Laminieren mit leitfähigen Materialien, wie z.B. Silber, Gold, Karbon oder Kupfer erzeugt.

### Bezugszeichenliste

- 2: Biegewandler
- 3: Längsrichtung
- 4: piezoelektrisch aktives Element
- 6: Piezokeramik
- 8: Elektrodenschicht
- 10: Schichtaufbau
- 12: mechanischer Träger
- 14A,B,: Schutzschicht
- 16: neutrale Zone
- 18: Leiterbahn
- 20: Biegerichtung
- 22: Kontaktfläche
- 24: Lagerungsstelle

- B: Breite
- D1: Dicke
- D2: Dicke
- D3: Dicke
- L: Länge

## Patentansprüche

1. Biegewandler (2) mit einem Schichtaufbau (10) umfassend ein piezoelektrisch aktives Element (4) bestehend aus einem piezoaktiven Material (6) und darauf angebrachten Elektrodenschichten (8), wobei der Schichtaufbau (10) außenseitig zwei Schutzschichten (14A, 14B) aufweist, wobei der Schichtaufbau (10) sandwichartig zwischen zwei die Schutzschichten (14A, 14B) bildende Folien angeordnet ist, **dadurch gekennzeichnet, dass** die Schutzschichten (14A, 14B) randseitig über den Schichtaufbau (10) überstehen und an ihrer dem Schichtaufbau (10) zugewandten Innenseite jeweils Leiterbahnen (18) aufweisen, über die das piezoelektrische Element (4) kontaktiert ist und die in Kontaktflächen (22) münden, die im überstehenden Teilbereich angeordnet sind und an denen im angeschlossenen Zustand eine, Anschlussleitung kontaktiert ist.

2. Biegewandler (2) nach Anspruch 1 **dadurch gekennzeichnet, dass** die Schutzschicht (14A, B) unter einer Vorspannung auf den Schichtaufbau (10) aufgebracht ist.

3. Biegewandler (2) nach Anspruch 1 oder 2, **dadurch gekennzeichnet, dass** die Schutzschicht (14A, 14B) einen im Vergleich zum Schichtaufbau (10) größeren thermischen Ausdehnungskoeffizienten aufweist.

4. Biegewandler (2) nach einem der vorhergehenden Ansprüche, **dadurch gekennzeichnet, dass** die Schutzschicht (14A, 14B) eine höhere Elastizität und / oder ein höheres E-Modul als der Schichtaufbau aufweist.

5. Biegewandler (2) nach einem der vorhergehenden Ansprüche, **dadurch gekennzeichnet, dass** die Dicke (D1, D2) der Schutzschicht größer 50µm ist und insbesondere im Bereich von 50 µm bis 1000µm liegt.

6. Biegewandler (2) nach einem der vorhergehenden Ansprüche mit einer neutralen Zone (16), **dadurch gekennzeichnet, dass** der Schichtaufbau (10) asymmetrisch bezüglich der neutralen Zone (16) angeordnet ist.

7. Biegewandler (2) nach Anspruch 6, **dadurch gekennzeichnet, dass** die Dicken (D1, D2) der beiden Schutzschichten (14A, 14B) unterschiedlich ausgebildet sind, so dass durch die unterschiedliche Dicken (D1, D2) der Schichtaufbau (10) asymmetrisch bezüglich der neutralen Zone (16) ist.

8. Biegewandler (2) nach Anspruch 7, **dadurch gekennzeichnet, dass** die Dicke (D2) der dickeren Schutzschicht (14B) größergleich der Gesamtdicke des Schichtaufbaus (10) und der dünneren Schutzschicht (14A) ist.

9. Biegewandler (2) nach einem der vorhergehenden Ansprüche, **dadurch gekennzeichnet, dass** die Schutzschicht (14A, 14B) eine auflaminierte Kunststofffolie ist.

10. Biegewandler (2) nach einem der Ansprüche 1 bis 8, **dadurch gekennzeichnet, dass** die Schutzschicht (14A, 14B) aus einem flexiblen Leiterplattenmaterial besteht.

11. Biegewandler (2) nach einem der vorhergehenden Ansprüche, **dadurch gekennzeichnet, dass** auf die Schutzschicht eine leitfähige Schicht aufgebracht ist, wobei die Schutzschicht (14A, 14B) insbesondere eine Tragschicht einer flexiblen Leiterplatte ist.

12. Biegewandler (2) nach Anspruch 11, **dadurch gekennzeichnet, dass** die leitfähige Schicht eine Elektrode des piezoelektrischen Elements (4) bildet.

13. Biegewandler nach einem der vorhergehenden Ansprüche , **dadurch gekennzeichnet, dass** die beiden Schutzschichten (14A, 14B) unterschiedlich weit über das piezoelektrische Element 4 überstehen, wobei in den dadurch gebildeten überstehenden Bereichen die Kontaktflächen (22) angeordnet sind.

14. Biegewandler (2) nach einem der Ansprüche 1 bis 8, **dadurch gekennzeichnet, dass** die Schutzschicht (14A, 14B) durch eine Lackschicht gebildet ist.

15. Biegewandler (2) nach einem der vorhergehenden Ansprüche, **dadurch gekennzeichnet, dass** er zumindest bis etwa 10% bei Druckbelastung gestaucht und / oder zumindest bis etwa 1% bei einer Dehnungsbelastung gedehnt werden kann, ohne beschädigt zu werden.

## Claims

1. Bending transducer (2) having a layer construction (10), comprising a piezoelectrically active element (4), consisting of a piezoactive material (6) and electrode layers (8) applied thereon, wherein the layer construction (10) has two protective layers (14A, 14B) on the outside, wherein the layer construction (10) is arranged in the manner of a sandwich between two films forming the protective layers (14A, 14B), **characterized in that** the protective layers (14A, 14B) project on the edge-side over the layer construction (10) and have in each case conductor tracks (18) on the inner side facing the layer construction (10), via which conductor tracks (18) the piezoelectric element (4) is contacted and which open in contact surfaces (22) which are arranged in the projecting partial region and on which in the connected state a connection line is contacted.

2. Bending transducer (2) according to Claim 1, **characterized in that** the protective layer (14A, 14B) is applied onto the layer construction (10) under a prestress.

3. Bending transducer (2) according to Claim 1 or 2, **characterized in that** the protective layer (14A, 14B) has a coefficient of thermal expansion that is greater than that of the layer construction (10).

4. Bending transducer (2) according to one of the preceding claims, **characterized in that** the protective layer (14A, 14B) has a higher elasticity and/or a higher modulus of elasticity than the layer construction.

5. Bending transducer (2) according to one of the preceding claims, **characterized in that** the thickness (D1, D2) of the protective layer is greater than 50 µm and in particular ranges from 50 µm to 1000 µm.

6. Bending transducer (2) according to one of the preceding claims with a neutral zone (16), **characterized in that** the layer construction (10) is arranged asymmetrically with respect to the neutral zone (16).

7. Bending transducer (2) according to Claim 6, **characterized in that** the thicknesses (D1, D2) of the two protective layers (14A, 14B) differ, such that the layer construction (10) is asymmetrical with respect to the neutral zone (16) on account of the different thicknesses (D1, D2).

8. Bending transducer (2) according to Claim 7, **characterized in that** the thickness (D2) of the thicker protective layer (14B) is greater than or equal to the overall thickness of the layer construction (10) and the thinner protective layer (14A).

9. Bending transducer (2) according to one of the preceding claims, **characterized in that** the protective layer (14A, 14B) is a laminated-on plastic film.

10. Bending transducer (2) according to one of Claims 1 to 8, **characterized in that** the protective layer (14A, 14B) is composed of a flexible printed-circuitboard material.

11. Bending transducer (2) according to one of the preceding claims, **characterized in that** a conductive layer is applied onto the protective layer, wherein the protective layer (14A, 14B) is in particular a carrier layer of a flexible printed-circuit board.

12. Bending transducer (2) according to Claim 11, **characterized in that** the conductive layer forms an electrode of the piezoelectric element (4).

13. Bending transducer according to one of the preceding claims, **characterized in that** the two protective layers (14A, 14B) project over the piezoelectric element (4) with different lengths, wherein in the projecting regions thus formed the contact surfaces (22) are arranged.

14. Bending transducer (2) according to one of Claims 1 to 8, **characterized in that** the protective layer (14A, 14B) is formed by a varnish layer.

15. Bending transducer (2) according to one of the preceding claims, **characterized in that** said bending transducer can be compressed at least to approximately 10% under a pressure load and/or elongated at least to approximately 1% under an elongation load, without being damaged.

## Revendications

1. Convertisseur de flexion (2) présentant une structure stratifiée (10) qui comprend un élément (4) piézoélectriquement actif constitué d'un matériau piézoactif (6) sur lequel sont appliquées des couches d'électrode (8),
la structure stratifiée (10) présentant du côté extérieur deux couches de protection (14a, 14b),
la structure stratifiée (10) étant disposée en sandwich entre deux films qui forment les couches de protection (14A, 14B),
**caractérisé en ce que**
les couches de protection (14A, 14B) débordent par leurs bords au-delà de la structure stratifiée (10) et présentent sur leur côté intérieur tourné vers la structure stratifiée (10) des pistes conductrices (18) qui aboutissent dans des surfaces de contact (22) disposées dans la partie en débord et par lesquelles l'élément piézoélectrique (4) est mis en contact et sur lesquelles un conducteur de raccordement est mis en contact en situation de raccordement.

2. Convertisseur de flexion (2) selon la revendication 1, **caractérisé en ce que** la structure de protection (14A, B) est appliquée sous précontrainte sur la structure stratifiée (10).

3. Convertisseur de flexion (2) selon les revendications 1 ou 2, **caractérisé en ce que** la couche de protection (14A, 14B) présente un coefficient de dilatation thermique supérieur à celui de la structure stratifiée (10).

4. Convertisseur de flexion (2) selon l'une des revendications précédentes, **caractérisé en ce que** la couche de protection (14A, 14B) présente une élasticité et/ou un module E plus élevés que la structure stratifiée.

5. Convertisseur de flexion (2) selon l'une des revendications précédentes, **caractérisé en ce que** l'épaisseur (D1, D2) de la couche de protection est supérieure à 50 µm et en particulier est comprise dans la plage de 50 µm à 1000 µm.

6. Convertisseur de flexion (2) selon l'une des revendications précédentes, présentant une zone neutre (16) et **caractérisé en ce que** la structure stratifiée (10) est disposée asymétriquement par rapport à la zone neutre (16).

7. Convertisseur de flexion (2) selon la revendication 6, **caractérisé en ce que** les épaisseurs (D1, D2) des deux couches de protection (14A, 14B) sont différentes, de telle sorte que la différence entre les épaisseurs (D1, D2) rende la structure stratifiée (10) asymétrique par rapport à la zone neutre (16).

8. Convertisseur de flexion (2) selon la revendication 7, **caractérisé en ce que** l'épaisseur (D2) de la couche de protection (14B) la plus épaisse est supérieure ou égale à l'épaisseur totale de la structure stratifiée (10) ou de la couche de protection (14A) la plus mince.

9. Convertisseur de flexion (2) selon l'une des revendications précédentes, **caractérisé en ce que** la couche de protection (14A, 14B) est un film de matière synthétique stratifié.

10. Convertisseur de flexion (2) selon l'une des revendications 1 à 8, **caractérisé en ce que** la couche de protection (14A, 14B) est constituée d'un matériau flexible de carte de circuit.

11. Convertisseur de flexion (2) selon l'une des revendications précédentes, **caractérisé en ce qu'**une couche conductrice est appliquée sur la couche de protection, la couche de protection (14A, 14B) étant en particulier une couche de support ou une carte flexible de circuit.

12. Convertisseur de flexion (2) selon la revendication 11, **caractérisé en ce que** la couche conductrice forme une électrode de l'élément piézoélectrique (4).

13. Convertisseur de flexion (2) selon l'une des revendications précédentes, **caractérisé en ce que** les deux couches de protection (14A, 14B) débordent sur des distances différentes au-delà de l'élément piézoélectrique (4), les surfaces de contact (22) étant disposées dans les parties en débord ainsi formées.

14. Convertisseur de flexion (2) selon l'une des revendications 1 à 8, **caractérisé en ce que** la couche de protection (14A, 14B) est formée de vernis.

15. Convertisseur de flexion (2) selon l'une des revendications précédentes, **caractérisé en ce qu'**il peut se contracter au moins jusqu'à environ 10 % sous une sollicitation en compression et/ou se dilater au moins jusqu'à environ 1 % lors d'une sollicitation en allongement sans être endommagé.
